# EUROPÄISCHE PATENTSCHRIFT

(11) **EP 3 317 036 B1**
(45) Veröffentlichungstag und Bekanntmachung des Hinweises auf die Patenterteilung: **18.05.2022**
(21) Anmeldenummer: 16741842.5
(22) Anmeldetag: 16.06.2016
(51) Int. Cl.: B22F 5/00, B22F 7/06, B22D 41/00, C23C 4/02, C23C 4/08, C23C 4/18, C23C 24/04, C30B 29/20, C30B 35/00, B22F 3/02, B22F 3/10, B22F 3/15

(54) **BEHÄLTER AUS REFRAKTÄRMETALL**
CONTAINER COMPOSED OF REFRACTORY METAL
CONTENANT EN MÉTAL RÉFRACTAIRE

(30) Priorität: 03.07.2015 AT 1952015 U
(43) Veröffentlichungstag der Anmeldung: 09.05.2018
(73) Patentinhaber: Plansee SE, 6600 Reutte (AT)
(72) Erfinder: SPRENGER, Dietmar, 6610 Wängle (AT); LANG, Bernhard, 6651 Häselgehr (AT); KATHREIN, Martin, 6531 (AT)
(74) Vertreter: Ciesla, Bettina
(86) Internationale Anmeldenummer: PCT/AT2016/000066
(87) Internationale Veröffentlichungsnummer: WO 2017/004630

(56) Entgegenhaltungen:
- CN-U- 202 530 198
- US-A1- 2014 174 341
- US-A1- 2015 128 849

## Beschreibung

Die Erfindung betrifft einen Behälter, der zumindest zwei miteinander verbundene Teile umfasst, wobei zumindest ein Teil aus Refraktärmetall oder einer Refraktärmetalllegierung mit einem Refraktärmetallgehalt > 80 Ma% besteht. Zudem betrifft die Erfindung ein Verfahren zur Herstellung eines Behälters, der zumindest bereichsweise aus Refraktärmetall oder einer Refraktärmetalllegierung mit einem Refraktärmetallgehalt > 80 Ma% besteht.

Unter dem Begriff Refraktärmetalle werden im Zusammenhang mit dieser Erfindung die Werkstoffe der 5. (Vanadium, Niob, Tantal) und 6. Gruppe (Chrom, Molybdän, Wolfram) des Periodensystems sowie Rhenium zusammengefasst. Diese Werkstoffe weisen unter anderem auch bei hohen Einsatztemperaturen eine ausgezeichnete Formbeständigkeit auf und sind gegenüber vielen Schmelzen chemisch beständig. So werden beispielsweise Behälter aus diesen Werkstoffen für das Schmelzen von Glas, Oxidkeramiken und Metallen eingesetzt.

Refraktärmetalle werden durch schmelz- oder pulvermetallurgische Verfahrenstechniken zu einer Vielzahl von Produkten verarbeitet. Für die Herstellung von Fertigteilen können jedoch übliche Schweißverfahren (zum Beispiel WIG) nur bedingt eingesetzt werden. Dies ist auf die Versprödung der Schweißnaht bzw. der Wärmeeinflusszone der Schweißnaht durch geringe Mengen von Gasen oder durch Kornvergröberung verbunden mit Segregation zurückzuführen. Geschweißte Behälter sind zum Beispiel in der CN 202530198 U oder der EP 2 657 372 A1 beschrieben. Neben der bereits erwähnten hohen Sprödigkeit ist auch die Korrosionsbeständigkeit reduziert, da an Korngrenzen segregierter Sauerstoff die Penetration von Schmelzen begünstigt.

Verbindungstechnische Verfahren, die zu keiner Gasaufnahme (zum Beispiel Elektronenstrahlschmelzen) oder Kornvergröberung (zum Beispiel Diffusionsschweißen) führen, sind sehr teuer und/oder bezüglich möglicher Geometrien sehr eingeschränkt anwendbar. Daher werden Behälter, die für das Schmelzen von Glas, Oxidkeramiken und Metallen eingesetzt werden, in industriellem Maßstab nur durch umformtechnische oder pulvermetallurgische Net-Shaping Verfahren hergestellt. Diesen Verfahren haften allerdings verfahrenstechnische oder ökonomische Nachteile an. So lassen sich Wolfram und deren Legierungen auf Grund werkstoffinherenter Sprödigkeit nicht zu großen Behältern umformen. Auch das Höhen- zu Durchmesserverhältnis ist begrenzt. Im Falle von durch pulvermetallurgischen Net-Shaping Verfahren hergestellten Behältern sind auch nachteilige Produkteigenschaften zu erwähnen. Diese Verfahren umfassen üblicherweise nur Pulverkompaktierung und Sintern, wodurch die Bauteildichte bei ca. 85 bis 95 % liegt. Da die Poren bevorzugt an Korngrenzen liegen, weisen so hergestellte Behälter gegenüber Schmelzen vielfach eine nicht ausreichende Korrosionsbeständigkeit auf, da die Schmelze entlang der durch die Poren geschwächten Korngrenzen nach außen penetrieren kann.

Ein beschichteter Behälter ist beispielsweise aus der WO 2010/072566 A1 bekannt. Dabei ist die Innenseite eines Tiegels, der aus einem Refraktärmetall gefertigt ist, zumindest teilweise mit einer Schutzschicht aus einem oxidischen Werkstoff, der im Temperaturbereich von 20°C bis 1.800°C keiner Phasenumwandlung unterliegt, bedeckt. Diese stellt einen zusätzlichen Herstellschritt dar, ohne dass dadurch die Probleme bei der Tiegelherstellung gelöst werden.

Die US2014174341A1 beschreibt einen Tiegel aus Refraktärmetall mit einer Innenauskleidung zur leichteren Entformung.

Die US2014174341A1 beschreibt einen Tiegel aus Refraktärmetall mit einer porösen Schicht auf der Innenseite des Tiegels zur leichteren Entformung.

Aufgabe der Erfindung ist es daher, einen Behälter bereitzustellen, der die zuvor geschilderten Nachteile nicht aufweist. Im Speziellen ist es Aufgabe der Erfindung, einen Behälter bereitzustellen, der eine ausgezeichnete Korrosionsbeständigkeit, insbesondere Korngrenzenkorrosionsbeständigkeit gegenüber keramischen, metallischen und Salzschmelzen aufweist.

Eine weitere Aufgabe der Erfindung ist die Bereitstellung eines Verfahrens, das kostengünstig zu dichten, korrosionsbeständigen Behältern führt.

Die Aufgabenstellung wird durch die unabhängigen Ansprüche gelöst. Vorteilhafte Ausführungsformen sind in den abhängigen Ansprüchen angeführt.

Als Behälter wird dabei ein Formteil bezeichnet, der in seinem Inneren einen Hohlraum aufweist, der insbesondere dem Zweck dient, seinen Inhalt von seiner Umwelt zu trennen. Der Behälter kann offen oder beispielsweise durch einen Deckel verschließbar sein.

Der Behälter umfasst dabei zumindest zwei Teile, die miteinander verbunden sind. Zumindest ein Teil besteht aus Refraktärmetall oder einer Refraktärmetalllegierung, wobei der Refraktärmetallgehalt > 80 Ma% beträgt. Unter dem Begriff Refraktärmetalle werden wie bereits erwähnt die Werkstoffe der 5. (Vanadium, Niob, Tantal) und 6. Gruppe (Chrom, Molybdän, Wolfram) des Periodensystems sowie Rhenium bezeichnet. Als weitere bevorzugte Komponenten der Refraktärmetalllegierung sind hochschmelzende, keramische Verbindungen, wie beispielsweise Oxide, die bevorzugt einen Schmelzpunkt von > 2.000°C aufweisen, zu nennen. Als bevorzugte Oxide sind die Oxide der Metalle der Gruppe Aluminium, Titan, Zirkon, Hafnium, Kalzium, Magnesium, Strontium, Yttrium, Scandium und Seltenerdmetalle anzuführen.

Der bevorzugte Refraktärmetallgehalt beträgt bevorzugt > 90 Ma%, insbesondere > 95 Ma%. Als besonders geeignete Refraktärmetalle sind Molybdän und Wolfram anzuführen. Auch Refraktärmetalle ohne weitere Legierungskomponenten oder Refraktärmetalllegierungen, bei denen alle Legierungskomponenten aus der Gruppe der Refraktärmetalle gewählt sind, stellen eine bevorzugte Ausführungsform der Erfindung dar. So eignen sich zum Schmelzen von Aluminiumoxid (zum Beispiel für Saphir-Einkristallziehverfahren) insbesondere technisch reines Molybdän, technisch reines Wolfram oder Molybdän-Wolfram Legierungen. Unter technischer Reinheit wird dabei das Metall mit üblichen herstellbedingten Verunreinigungen bezeichnet.

Des Weiteren besteht der gesamte Behälter bevorzugt aus Refraktärmetall oder einer Refraktärmetalllegierung mit einem Refraktärmetallgehalt > 80 Ma%.

Die zumindest zwei Teile sind nun zumindest bereichsweise über eine thermische Spritzschicht miteinander verbunden. Eine thermische Spritzschicht kann ein Fachmann in eindeutiger Weise aufgrund ihrer Gefügestruktur erkennen. So verformen sich die Spritzpartikel beim Auftreffen auf dem Substrat, so dass die für thermische Spritzschichten typische "Pancake-Struktur" entsteht.

Zu den thermischen Spritzverfahren zählen das Schmelzbadspritzen, Lichtbogenspritzen, Plasmaspritzen, Flammspritzen, Hochgeschwindigkeitsflammspritzen, Detonationsspritzen, Kaltgasspritzen, Laserspritzen und PTWA (plasma transferred wire arc) Spritzen. Beim Plasmaspritzen unterscheidet man wieder in Abhängigkeit von der Spritzatmosphäre das atmosphärische Plasmaspritzen, das Plasmaspritzen unter Schutzgas sowie das Vakuumplasmaspritzen.

Überraschenderweise hat sich nun herausgestellt, dass die thermische Spritzschicht mit den zu verbindenden Teilen eine ausgezeichnete Verbindung bildet, die es ermöglicht, Behälter herzustellen, die die erfindungsgemäße Aufgabenstellung erfüllen. Insbesondere überraschend ist, dass diese Behälter eine ausgezeichnete Dichtigkeit gegenüber Schmelzen, wie beispielsweise keramischen Schmelzen, zeigen. Auch im Langzeiteinsatz weist die Verbindungszone Spritzschicht / Teil eine hohe Beständigkeit gegenüber der Penetration von Schmelzen auf. Ein weiterer wichtiger Vorteil besteht darin, dass der erfindungsgemäße Behälter eine Formenvielfalt (zum Beispiel in Bezug auf Durchmesser (bei Rundbehälter), Länge / Breite (bei Rechteckbehälter) und Höhe aufweisen kann, die mit Tiegel gemäß dem Stand der Technik nicht realisierbar ist.

Bevorzugt ist die Bindezone Spritzschicht / Teil als stoffschlüssige und/oder formschlüssige Verbindung ausgebildet.

Unter stoffschlüssiger Verbindung werden alle Verbindungen zusammengefasst, bei denen die Verbindungspartner durch atomare oder molekulare Kräfte zusammengehalten werden. So weisen beispielsweise beim Plasmaspritzen die Spritztröpfchen eine Temperatur auf, die über der jeweiligen Solidustemperatur liegt. Auch das Substrat ist üblicherweise erwärmt. Beim Auftreffen der Spritztröpfchen auf dem Substrat kommt es durch Diffusion und/oder chemischer Reaktion zur Ausbildung einer stoffschlüssigen Verbindung. Ein Fachmann kann durch eine werkstoffkundliche Untersuchung eine stoffschlüssige Verbindung in eindeutiger Weise von anderen Verbindungstechniken unterscheiden.

Unter einer formschlüssigen Verbindung versteht man eine Verbindung, die durch das Ineinandergreifen von mindesten zwei Verbindungspartnern entsteht. Weisen die zu verbindenden Teile beispielsweise eine Rauheit auf, so werden beim thermischen Spritzen die Vertiefungen mit dem Spritzmaterial gefüllt. Dadurch stellen sich ein Verzahnungseffekt und damit eine formschlüssige Verbindung ein.

Ein Fachmann kann auch eine formschlüssige Verbindung in eindeutiger Weise von anderen Verbindungstechniken unterscheiden.

In besonders bevorzugter Weise ist die Verbindung stoffschlüssig oder stoffschlüssig und formschlüssig ausgebildet.

Des Weiteren ist die Spritzschicht bevorzugt als Naht ausgebildet. Die Naht ist dabei bevorzugt aus vielen Spritzlagen gebildet. Obwohl die erfindungsgemäße Verbindung nicht den Schweißverbindungen zuzuordnen ist, erfolgt im Nachfolgenden die Definition bzw. Beschreibung der Nahtform entsprechend den Gepflogenheiten im Bereich der Schweißtechnik. Anstelle des Schweißzusatzwerkstoffs bildet bei der gegenständlichen Erfindung das Schichtmaterial die Naht. Die Beschreibung der Nahtformen kann üblichen Lehrbüchern, wie beispielswiese Dubbel, Taschenbuch für den Maschinenbau, 20. Auflage, Springer-Verlag, ISBN 3-540-67777-1, G10 entnommen werden.

Bevorzugt ist die Spritznaht als U-, V-, Y- oder I-Naht ausgebildet. Auch eine Kehlnaht stellt eine bevorzugte Ausführungsform dar. Besonders bevorzugte Nahtformen sind die U- und die V-Naht. Der Öffnungswinkel der V- oder U-Naht kann in einem weiten Bereich gewählt werden, wobei auch Winkel, die über den üblichen Bereich von Schweißnähten hinausreichen, gewählt werden können.

Ein bevorzugter Bereich beträgt 45° bis 230°. Derart große Winkel können mit üblichen Schweißverfahren nicht erzielt werden. Bei einem Winkel > 180° schließt das V den Bereich der zu verbindenden Teile ein. Bei größeren Stärken der zu verbindenden Teile kann auch eine Doppel-V-Naht (X-Naht) oder eine Doppel-U-Naht besonders vorteilhaft sein. Im Fall eines Parallelstoßes eignen sich Kehlnähte zu einer sicheren Verbindung von zwei oder mehreren Teilen.

Neben der Nahtform sind auch andere Ausführungsformen, wie zum Beispiel eine Verbindung durch eine flächig aufgebrachte Spritzschicht, möglich und vorteilhaft.

In vorteilhafter Weise werden vor dem Aufbringen der Spritzschicht die zu verbindenden Teile zueinander durch eine formschlüssige Verbindung fixiert oder miteinander verbunden. Dazu sind die Teile zumindest bereichsweise so ausgebildet, dass dies eine formschlüssige Verbindung ermöglicht. Als besonders vorteilhafte formschlüssige Verbindungen sind die Nut-Feder- und die Passfeder-Verbindung sowie das Verstiften zu nennen.

Es ist jedoch auch möglich und vorteilhaft, vor dem Aufbringen der Spritzschicht die zu verbindenden Teile durch einen Kraftschluss zueinander zu fixieren oder miteinander zu verbinden. Vorteilhafte kraftschlüssige Verbindungen sind Press-, Schrumpf und Keilverbindungen.

Durch Verstemmen wird sowohl eine form- als auch kraftschlüssige Verbindung erzielt. Die zu verbindenden Teile durch Verstemmen zueinander zu fixieren oder miteinander zu verbinden, stellt eine bevorzugte Ausführungsform der Erfindung dar.

Des Weiteren ist es vorteilhaft, vor dem Aufbringen der Spritzschicht die zu verbindenden Teile durch eine örtliche stoffschlüssige Verbindung, zum Beispiel durch Punktschweißen, zueinander zu fixieren oder miteinander zu verbinden.

In vorteilhafter Weise ist wie bereits erwähnt das Refraktärmetall Molybdän oder Wolfram. Vorteilhafte Molybdän- bzw. Wolframlegierungen sind Mo-W-Legierungen im gesamten Konzentrationsbereich sowie Molybdän- oder Wolfram-Basis-Legierungen mit einem Molybdän- bzw. Wolfram-Gehalt von > 80 Ma%, vorteilhaft > 90 Ma%, insbesondere vorteilhaft > 95 Ma%, wobei der Rest vorteilhaft ein hochschmelzendes Oxid ist. Das Oxid liegt dabei in vorteilhafter Weise in fein verteilter Form im Basiswerkstoff vor.

Besonders vorteilhafte Werkstoffe sind in der nachfolgenden Liste zusammengefasst:
- Mo (Reinheit > 99,5 Ma%)
- W (Reinheit > 99,5 Ma%)
- Mo-W Legierung mit 0,5 Ma% < W < 99,5 Ma%
- Mo-0,01 bis 20 Ma% zumindest eines Oxids ausgewählt aus der Gruppe bestehend aus HfO₂, ZrO₂, TiO₂, Al₂O₃, Y₂O₃, SC₂O₃, Seltenerdmetalloxid, SrO, CaO und MgO.
- Mo-0,01 bis 20 Ma% Mischoxid, das zumindest zu 50 Mol% aus einem Oxid ausgewählt aus der Gruppe bestehend aus HfO₂, ZrO₂, TiO₂, Al₂O₃, Y₂O₃, SC₂O₃, Seltenerdmetalloxid, SrO, CaO und MgO besteht.
- W-0,01 bis 20 Ma% zumindest eines Oxids ausgewählt aus der Gruppe bestehend aus HfO₂, ZrO₂, TiO₂, Al₂O₃, Y₂O₃, SC₂O₃, Seltenerdmetalloxid, SrO, CaO und MgO.
- W-0,01 bis 20 Ma% Mischoxid, das zumindest zu 50 Mol% aus einem Oxid ausgewählt aus der Gruppe bestehend aus HfO₂, ZrO₂, TiO₂, Al₂O₃, Y₂O₃, SC₂O₃, Seltenerdmetalloxid, SrO, CaO und MgO besteht.
- Mo-W Legierung (0,5 Ma% < W < 99,5 Ma%) - 0,01 bis 20 Ma% zumindest eines Oxids ausgewählt aus der Gruppe bestehend aus HfO₂, ZrO₂, TiO₂, Al₂O₃, Y₂O₃, Sc₂O₃, Seltenerdmetalloxid, SrO, CaO und MgO.
- Mo-Ta Legierung mit 0,1 Ma% < Ta < 99 Ma%
- Mo-Nb Legierung mit 0,1 Ma% < Nb < 99 Ma%
- Mo-Cr Legierung mit 0,1 Ma% < Cr < 99 Ma%
- Mo-Re Legierung mit 0,1 Ma% < Re < 50 Ma%
- W-Ta Legierung mit 0,1 Ma% < Ta < 99 Ma%
- W-Nb Legierung mit 0,1 Ma% < Nb < 99 Ma%
- W-Cr Legierung mit 0,1 Ma% < Cr < 99 Ma%
- W-Re Legierung mit 0,1 Ma% < Re < 26 Ma%
- Nb (Reinheit > 99,5 Ma%)
- Ta (Reinheit > 99,5 Ma%)
- V (Reinheit > 99,5 Ma%)
- Re (Reinheit > 99,5 Ma%)
- Cr (Reinheit > 99,5 Ma%)

Im Weiteren ist es vorteilhaft, wenn die Spritzschicht durch Plasmaspritzen gebildet ist. Beim Plasmaspritzen wird der Beschichtungsstoff durch die hohe Plasmatemperatur aufgeschmolzen. Der Plasmastrom reist die Partikeln mit und schleudert sie auf die zu verbindenden Teile. Durch die hohe Temperatur der Partikeln beim Auftreffen auf den zu verbindenden Teilen ist gewährleistet, dass sich zuverlässig zwischen der Spritzschicht und den zu verbindenden Teilen eine stoffschlüssige Verbindung ausbildet. In vorteilhafter Weise werden vor dem Aufbringen der Spritzschicht die zu verbindenden Teile auf eine Temperatur > 500°C, bevorzugt > 1000°C, insbesondere bevorzugt > 1500°C angewärmt. Der vorteilhafte Bereich wird nach oben hin durch den Schmelzpunkt der zu verbindenden Teile begrenzt. Das Plasmaspritzen erfolgt bevorzugt in einer Schutzgasatmosphäre (z.B. Argon) oder in Vakuum. Letztere Ausführungsform ist eine besonders vorteilhafte Ausgestaltung der Erfindung, da durch einen Beschichtungsprozess im Vakuum gewährleistet ist, dass sich im Bereich der Grenzfläche Spritzschicht / Teil keine Oxidschicht oder Oxidbereiche ausbilden können, die sich sowohl auf die Verbindungsfestigkeit, als auch auf die Korngrenzen-Korrosionsbeständigkeit nachteilig auswirkt / auswirken.

Bevorzugte Werkstoffe für die Spritzschicht sind nachfolgender Tabelle zu entnehmen.
- Mo (Reinheit > 99,5 Ma%)
- W (Reinheit > 99,5 Ma%)
- Mo-W Legierung mit 0,5 Ma% < W < 99,5 Ma%
- Mo-0,01 bis 20 Ma% zumindest eines Oxids ausgewählt aus der Gruppe bestehend aus HfO₂, ZrO₂, TiO₂, Al₂O₃, Y₂O₃, Sc₂O₃, Seltenerdmetalloxid, SrO, CaO und MgO.
- Mo-0,01 bis 20 Ma% Mischoxid, das zumindest zu 50 Mol% aus einem Oxid ausgewählt aus der Gruppe bestehend aus HfO₂, ZrO₂, TiO₂, Al₂O₃, Y₂O₃, Sc₂O₃, Seltenerdmetalloxid, SrO, CaO und MgO besteht.
- W-0,01 bis 20 Ma% zumindest eines Oxids ausgewählt aus der Gruppe bestehend aus HfO₂, ZrO₂, TiO₂, Al₂O₃, Y₂O₃, Sc₂O₃, Seltenerdmetalloxid, SrO, CaO und MgO.
- W-0,01 bis 20 Ma% Mischoxid, das zumindest zu 50 Mol% aus einem Oxid ausgewählt aus der Gruppe bestehend aus HfO₂, ZrO₂, TiO₂, Al₂O₃, Y₂O₃, Sc₂O₃, Seltenerdmetalloxid, SrO, CaO und MgO besteht.
- Mo-W Legierung (0,5 Ma% < Mo < 99,5 Ma%) - 0,01 bis 20 Ma% zumindest eines Oxids ausgewählt aus der Gruppe bestehend aus HfO₂, ZrO₂, TiO₂, Al₂O₃, Y₂O₃, Sc₂O₃, Seltenerdmetalloxid, SrO, CaO und MgO.
- Mo-Ta Legierung mit 0,1 Ma% < Ta < 99 Ma%
- Mo-Nb Legierung mit 0,1 Ma% < Nb < 99 Ma%
- Mo-Cr Legierung mit 0,1 Ma% < Cr < 99 Ma%
- Mo-Re Legierung mit 0,1 Ma% < Re < 50 Ma%
- W-Ta Legierung mit 0,1 Ma% < Ta < 99 Ma%
- W-Nb Legierung mit 0,1 Ma% < Nb < 99 Ma%
- W-Cr Legierung mit 0,1 Ma% < Cr < 99 Ma%
- W-Re Legierung mit 0,1 Ma% < Re < 26 Ma%
- Nb (Reinheit > 99,5 Ma%)
- Ta (Reinheit > 99,5 Ma%)
- V (Reinheit > 99,5 Ma%)
- Re (Reinheit > 99,5 Ma%)
- Cr (Reinheit > 99,5 Ma%)

Eine weitere bevorzugte Ausgestaltung der Erfindung liegt vor, wenn sowohl die Spritzschicht als auch die zu verbindenden Teile aus Refraktärmetall oder einer Refraktärmetalllegierung gebildet sind. Besonders vorteilhaft ist es, wenn Spritzschicht und zu verbindende Teile aus dem gleichen Werkstoff bestehen oder im Falle einer Legierung zumindest das gleiche Basismaterial aufweisen.

Des Weiteren ist der Behälter vorteilhaft als Rundbehälter, z.B. als Tiegel, ausgebildet. In vorteilhafter Weise wird dabei der Rundbehälter durch zumindest zwei Teile, die als Hohlzylindersegmente ausgebildet sind, und zumindest einem Bodenteil gebildet.

Es ist jedoch auch möglich und vorteilhaft, den Behälter als Rechteckbehälter zu gestalten. Bevorzugt wird der Rechteckbehälter durch zumindest zwei Seitenteile und zumindest einen U- oder plattenförmigen Bodenteil gebildet. Rechteckbehälter können nach dem Stand der Technik nur durch Netshape-Press/Sinterverfahren hergestellt werden. Umformtechnisch, zum Beispiel durch Tiefziehen, ist eine Herstellung von größeren Rechteckbehältern nicht möglich. Durch die gegenständliche Erfindung ist es damit möglich, auch Rechteckbehälter mit sehr hoher Dichte zu fertigen. Auch bezüglich der Tiegelabmessungen sind in einem weiten Bereich keine Grenzen gegeben. So lassen sich beispielsweise sehr großformatige Tiegel herstellen.

Bevorzugt wird die hohe Dichte des Behälters dadurch erreicht, dass die zu verbindenden Teile (z.B. Hohlzylinder und Bodenteil) aus verformtem Material hergestellt sind. So ist es beispielsweise möglich, ein Hohlzylindersegment durch Pressen, Sintern, Walzen und Biegen herzustellen. Der Bodenteil kann ebenfalls aus einer gewalzten Platte gefertigt werden. Die zu verbindenden Teile können einfach und kostengünstig durch übliche Verfahren bearbeitet werden.

In vorteilhafter Weise ist die Spritzschicht des Behälters dicht gegenüber einer keramischen Schmelze (zum Beispiel Al₂O₃). Materialschädigungen, wie zum Beispiel Korngrenzenverunreinigungen, Poren an Korngrenzen und Korngrenzenrisse können die Dichtigkeit eines Schmelzbehälters stark reduzieren. Es ist daher für den Fachmann sehr überraschend, dass eine Spritzschicht, die üblicherweise ebenfalls Materialdeffekte aufweist, auch über sehr lange Zeiten dicht gegenüber einer Al₂O₃-Schmelze ist. Anders als bei gepressten und gesinterten Teilen (Poren liegen hauptsächlich an den Korngrenzen) beeinflussen Poren in der Spritzschicht, die zum großen Teil in isolierter Form vorliegen, die Dichtigkeit in geringerem Ausmaß.

Die Spritzschicht kann vorteilhaft nicht nur als Verbindungselement zwischen den Teilen dienen, sondern auch, in flächiger Form aufgebracht, die Dichtigkeit der Teile verbessern. Dies ist insbesondere bei nur gepresst / gesinterten Teilen vorteilhaft. Die Spritzschicht kann dabei in einfacher Weise vor dem Verbindungsprozess aufgebracht werden. Damit ist es in einfacher Weise möglich, Behälter herzustellen, die innen und/oder außenseitig zumindest teilweise mit einer thermischen Spritzschicht versehen sind.

Die relative Dichte (gemessene Dichte bezogen auf theoretische Dichte) der Spritzschicht im Bereich der Verbindungszone und/oder der flächig aufgebrachten Spritzschicht beträgt bevorzugt > 95 %. Ausgezeichnete Resultate können erzielt werden, wenn die relative Dichte > 98 %, insbesondere vorteilhaft > 99 %, beträgt.

Mit dem erfindungsgemäßen Behälter ist es möglich, prozesssicher Saphir-Einkristalle nach üblichen Herstellmethoden (Kyropoulos, HEM, EFG, CHES, Bagdasarov oder Czochralski-Prozess) herzustellen. Dies gewährleistet sowohl eine längere Standzeit des Schmelzbehälters, als auch eine höhere Prozesssicherheit. Zudem wird eine teilweise Zerstörung der Einkristall-Wachstumsanlage vermieden, wie dies im Falle austretender Keramikschmelze der Fall sein kann.

Die gegenständliche Aufgabenstellung wird auch durch ein Verfahren zur Herstellung eines Behälters gelöst. Der Behälter besteht dabei zumindest bereichsweise aus Refraktärmetall oder einer Refraktärmetalllegierung, wobei der Refraktärmetallgehalt > 80 Ma% beträgt.

Der Prozess umfasst dabei zumindest die folgenden Schritte:
- Herstellen von zumindest zwei Teilen,
- zumindest bereichsweises Aufbringen einer thermischen Spritzschicht, so dass die Spritzschicht zumindest bereichsweise zwischen zumindest zwei Teilen zumindest eine Verbindung ausgewählt aus der Gruppe bestehend aus Stoffschluss und Formschluss bildet.

Die Herstellung der Teile erfolgt vorteilhaft durch übliche pulvermetallurgische und/oder umformtechnische Verfahren. So können beispielsweise die Teile durch Pressen, Sintern und anschließendem Umformen, beispielsweise Walzen, hergestellt werden. Weitere Umformschritte schließen vorteilhaft Biegen oder Prägen ein. Auch die Herstellung durch heißisostatisches Pressen (HIPen), optional gefolgt von einem Umformprozess, stellt ein bevorzugtes Verfahren dar.

Das Aufbringen der thermischen Spritzschicht erfolgt bevorzugt durch Schmelzbadspritzen, Lichtbogenspritzen, Plasmaspritzen, Flammspritzen, Hochgeschwindigkeitsflammspritzen, Detonationsspritzen, Kaltgasspritzen, Laserspritzen oder PTWA (Plasma Transferred Wire Arc) Spritzen. Bei diesen Spritzverfahren ist gewährleistet, dass beim Auftreffen des Beschichtungsstoffs dessen Temperatur und/oder Energie so hoch ist, dass sich zuverlässig eine stoffschlüssige und/oder formschlüssige Verbindung ausbildet. Die formschlüssige Verbindung bildet sich bevorzugt durch den bereits beschriebenen Verzahnungseffekt aus. Dieser Verzahnungseffekt kann noch verstärkt werden, wenn die Verbindungszone entsprechend gestaltet wird. Eine einfache Möglichkeit stellt die Herstellung von Rillen durch entsprechende mechanische Bearbeitung dar.

Beim Kaltgasspritzen (wird ebenfalls zu den thermischen Spritzverfahren gezählt) kann die stoffschlüssige Verbindung nur schwach (durch Mikroverschweißen) ausgebildet sein. Da jedoch die Auftreffgeschwindigkeit der Partikeln beim Kaltgasspritzen typischerweise im Bereich von 400 bis 1.200 m/s oder darüber beträgt, dringen die Partikeln des Beschichtungsstoffes in das Substratmaterial ( = zu verbindender Teil) ein, wodurch auch hier zuverlässig, auch ohne eine zusätzliche Vorbearbeitung, eine formschlüssige Verbindung gebildet wird.

In vorteilhafter Weise weist der Behälter zumindest eine der folgenden Eigenschaften auf:
- Die Spritzschicht ist als Naht ausgebildet.
- Die Naht weist eine U, V, Y oder I Form auf oder ist als Kehlnaht ausgebildet.
- Die zu verbindenden Teile sind zumindest bereichsweise so ausgebildet, dass diese durch einen Form- oder Stoffschluss zueinander fixiert oder miteinander verbunden sind.
- Das Refraktärmetall ist Molybdän oder Wolfram.
- Die Spritzschicht ist durch Plasmaspritzen gebildet.
- Die Spritzschicht und die verbindenden Teile bestehen aus Refraktärmetall oder einer Refraktärmetalllegierung.
- Der Behälter ist als Rundbehälter ausgebildet.
- Der Rundbehälter ist durch zumindest zwei Teile, die als Hohlzylindersegmente ausgebildet sind, und zumindest einem Bodenteil gebildet.
- Der Behälter ist als Rechteckbehälter ausgebildet.
- Der Rechteckbehälter ist durch zumindest zwei Seitenteile und zumindest einem U oder plattenförmigen Bodenteil gebildet.
- Die Spritzschicht ist dicht gegenüber einer keramischen Schmelze.

In vorteilhafter Weise werden die zu verbindenden Teile vor dem Aufbringen der Spritzschicht mechanisch so bearbeitet, dass diese zumindest bereichsweise form-, kraft- und/oder stoffschlüssig zueinander fixiert oder miteinander verbunden werden können. Besonders vorteilhafte Verbindungen stellen dabei die Nut-Feder-, Stift-, Press- und Schrumpfverbindung dar.

Im Weiteren werden die Teile vorteilhaft bevorzugt mechanisch so bearbeitet, dass das Verbinden der Teile durch eine thermisch gespritzte Naht möglich ist.

Als besonders vorteilhaftes thermisches Spritzverfahren ist das Plasmaspritzen, und hier wiederum das Vakuum-Plasmaspritzen zu nennen. Beim Vakuum-Plasmaspritzen wird das Material für die Spritzschicht als Pulver in einen, durch eine DC-Bogenentladung erzeugten Plasmastrahl vorteilhaft radial eingebracht, im Plasmastrahl erschmolzen und die erschmolzenen Tröpfchen auf einem Grundkörper abgeschieden. Da der Prozess im Unterdruck ausgeführt wird, wird eine Oxidation des Beschichtungsmaterials vermieden. Ein besonders vorteilhaftes Verfahren stellt dabei das induktive Vakuum-Plasmaspritzen (IVPS) dar. Ein wesentlicher Unterschied zum konventionellen Plasmaspritzen liegt darin, dass das Plasma durch induktive Aufheizung erzeugt wird, wodurch das Spritzpulver auf einfache Weise bereits vor der Ausbildung des Plasmastrahls axial eingebracht werden kann. Dadurch, und durch die in Folge der induktiven Aufheizung geringere Expansionsgeschwindigkeit des Plasmas, verweilen die Pulverpartikel wesentlich länger im Plasmastrahl. Damit verbessert sich die Energieübertragung vom Plasma auf die einzelnen Partikeln des Spritzpulvers, so dass auch größere Partikel vollständig über ihre Schmelztemperatur erhitzt werden und als voll erschmolzene Tröpfchen abgeschieden werden können. Somit ist es möglich, auch ohne Beeinträchtigung der Schichtqualität kostengünstigere Spritzpulver mit einer breiteren Partikelgrößenverteilung einzusetzen. Das sich beim induktiven Plasmaspritzen einstellende Gefüge weist im Vergleich zu konventionell hergestellten plasmagespritzten Schichten eine noch weiter verbesserte Dichtigkeit (relative Dichte bevorzugt > 98 %) gegenüber auch sehr dünnflüssigen keramischen Schmelzen auf. Auch die niedrige Relativgeschwindigkeit, mit der der Plasmastrahl die zu beschichtende Oberfläche überstreicht, erweist sich als vorteilhaft. Auch der vergleichsweise größere Strahldurchmesser wirkt sich günstig auf den Beschichtungsprozess aus.

Eine weitere Verbesserung der stoffschlüssigen Verbindung kann erzielt werden, wenn die zu verbindenden Teile mit dem Plasmastrahl vorgeheizt werden, beispielsweise auf eine Temperatur größer 700°C (zum Beispiel 700 bis 2.000°C).

Wird ein Verfahren angewandt, das zu einer Verbindungszone mit niedriger Dichte führt, kann die Verbindungszone durch das Einwirken eines Slurrys, optional gefolgt von einer Glühung, versiegelt werden. Die Pulverpartikel des Slurrys bestehen dabei vorteilhaft ebenfalls aus einem Refraktärmetall oder einer Refraktärmetalllegierung, wobei vorteilhaft die mittlere Partikelgröße (gemessen mittels Laserbeugung) < 1 µm beträgt. In besonders vorteilhafter Weise eignen sich die erfinderischen Behälter zum Aufschmelzen von Aluminiumoxid nach üblichen Verfahren, wie beispielsweise dem Kyropoulos, HEM, EFG, CHES, Bagdasarov oder Czochralski Prozess.

Im Folgenden wird die Erfindung beispielhaft beschrieben. Figur 1 bis 17 stellen dabei erfindungsgemäße Ausführungsformen dar.
- Figur 1: zeigt in einer Explosionsdarstellung schematisch die Teile eines Rundbehälters vor dem Fügeprozess.
- Figur 2: zeigt schematisch einen Rundbehälter, aufgebaut aus den Teilen gemäß Figur 1, im stoffschlüssig gefügten Zustand.
- Figur 3: zeigt schematisch einen Rechteckbehälter im stoffschlüssig gefügten Zustand.
- Figur 4: zeigt schematisch einen Rechteckbehälter im stoffschlüssig gefügten Zustand.
- Figur 5: zeigt ein Foto eines stoffschlüssig gefügten Rechteckbehälters, der vollständig aus Mo (die Bezeichnung Mo wird in den Beispielen für Mo mit technischer Reinheit verwendet) gefertigt wurde.
- Figur 6: zeigt schematisch zwei Teile, stoffschlüssig durch eine V-Naht verbunden.
- Figur 7: zeigt schematisch zwei Teile, stoffschlüssig durch eine U-Naht verbunden, sowie eine Spritzschicht zur außenseitigen Abdichtung.
- Figur 8: zeigt schematisch zwei Teile, formschlüssig zueinander durch eine Stiftverbindung fixiert und stoffschlüssig durch eine U-Naht verbunden, sowie eine Spritzschicht zur außenseitigen Abdichtung.
- Figur 9: zeigt schematisch zwei Teile, form- und kraftschlüssig zueinander durch Verstemmen fixiert und stoffschlüssig durch eine U-Naht verbunden, sowie eine Spritzschicht zur innenseitigen und eine Spritzschicht zur außenseitigen Abdichtung.
- Figur 10: zeigt schematisch zwei Teile, formschlüssig zueinander durch eine Nut-Feder-Verbindung fixiert und stoffschlüssig durch eine U-Naht verbunden, sowie eine Spritzschicht zur innenseitigen und eine Spritzschicht zur außenseitigen Abdichtung.
- Figur 11: zeigt schematisch zwei zueinander durch eine Nut-Feder-Verbindung formschlüssig fixierte Teile, eine außenseitig aufgebrachte Spritzschicht zur stoffschlüssigen Verbindung sowie Abdichtung und eine innenseitig angebrachte Spritzschicht zur Abdichtung.
- Figur 12: zeigt schematisch zwei zueinander durch eine Nut-Feder-Verbindung formschlüssig fixierte Teile, stoffschlüssig durch eine U-Naht verbunden.
- Figur 13: zeigt schematisch zwei durch eine Nut-Feder-Verbindung formschlüssig fixierte Teile sowie eine Spritzschicht zur Abdichtung und eine Spritzschicht zur stoffschlüssigen Verbindung.
- Figur 14: zeigt schematisch zwei zueinander form- und kraftschlüssig durch Verstemmen fixierte Teile, stoffschlüssig durch eine U-Naht verbunden.
- Figur 15: zeigt eine rasterelektronenmikroskopische Aufnahme der Fügezone Mo Teil - Mo Spritzschicht.
- Figur 16: zeigt eine lichtmikroskopische Aufnahme einer gespritzten (IVPS) W Schicht (relative Dichte 99 %), die auf einem gepresst gesinterten W-Teil (relative Dichte 95 %) aufgebracht wurde.

### Beispiel 1:

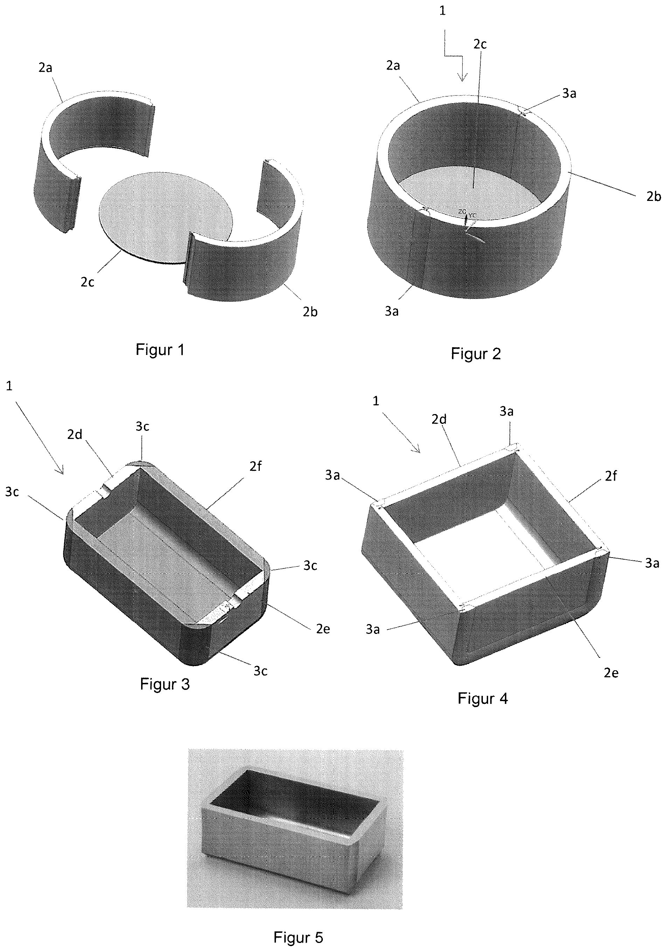

Für die Herstellung eines Mo-Rechteckbehälters (1) gemäß Figur 3 wurden folgende Teile (2d,e,f) eingesetzt:
- Teil (2f), der die Boden- und Seitenflächen längsseitig bildet: U-förmig geschmiedete Mo Platte, allseitig bearbeitet und geschliffen, Wandstärke 9,5 mm
- Teile (2d,e), die die Seitenflächen breitseitig bilden: Gewalzte Mo Platten allseitig bearbeitet und geschliffen, Wandstärke 9,5 mm

Alle Teile (2d,e,f) wurden auf den zu verbindenden Flächen mittels Fräsen mit einer 45°-Fase versehen. Ein formschlüssiges Fixieren wurde über die Herstellung einer weiteren Fase (Fügespalt mit 1 mm, 45°) an den Stirnflächen sowie über eine mechanische Verklammerung mit einer externen Halterung (zugleich Halterung für den Beschichtungsprozess) mit Verschraubungen erzeugt.

Das stoffschlüssige Verbinden der Teile (2d,e,f) erfolgte jeweils über eine thermisch gespritzte Schicht (3c), die durch IVPS hergestellt wurde. Dazu wurden die aufgespannten Teile in einer Halterung in einer vakuumtauglichen Spritzkammer montiert. Für den Spritzprozess wurde ein handelsübliches Mo Plasma-Spritzpulver verwendet.

Der IVPS-Spritzprozess wurde mit für Refraktärmetallen üblichen Parametern (siehe beispielsweise EP 0 874 385 A1) durchgeführt. Nach dem Spritzprozess wurde der Rechteckbehälter (1) aus der Vakuumkammer entnommen und die Stirnflächen mittels zerspanender Bearbeitung (Fräsen, Schleifen) bearbeitet. Ein Foto des Rechteckbehälters (1) ist in Figur 5 wiedergegeben.

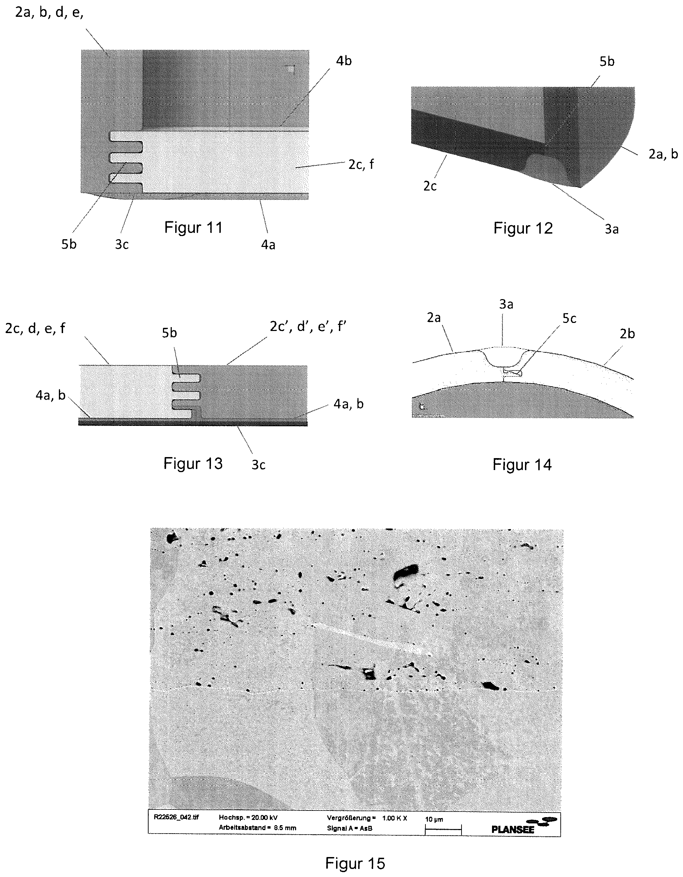

In weiterer Folge wurde in diesem Rechteckbehälter (1) Aluminiumoxid unter Schutzgas (Ar) aufgeschmolzen. Während bei der Herstellung von Saphir-Einkristallen die übliche Temperatur der Schmelze ca. 2150°C beträgt, wurde der Schmelzprozess bei 2300°C durchgeführt, um verschärfte Bedingungen zu simulieren. Die Versuchszeit betrug 24 h. Danach wurde der Rechteckbehälter (1) metallographisch untersucht. Es konnte keine Penetration von Aluminiumoxid im Bereich der stoffschlüssigen Verbindung (siehe Figur 15) festgestellt werden.

### Beispiel 2

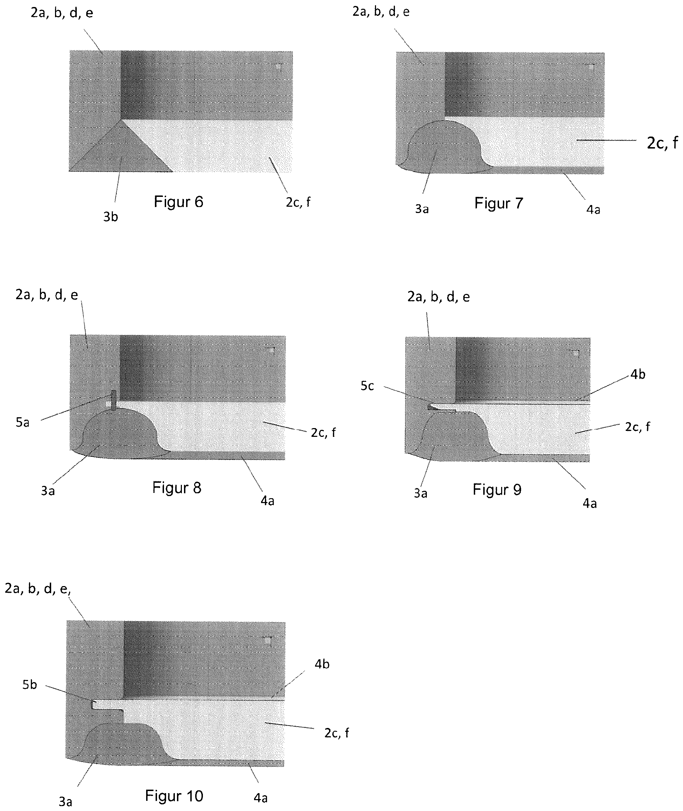

Für die Herstellung eines W-Rundbehälters (1) gemäß Figur 2 wurden folgende Teile (2a,b,c) eingesetzt (siehe Figur 1):
- Zwei Hohlzylindersegmente (2a,b): Die Hohlzylindersegmente (2a,b) wurden aus W-Sinterplatten hergestellt, die einseitig auf eine Dicke von 20 mm gefräst wurden. Die Platten wurden zu Halbschalen (2a,b) geformt. Die Teile (2a,b) wurden an den zu verbindenden Stößen mittels Kontourfräsen mit einem Profil (5c) entsprechend Figur 14 (Verbindung zwischen (2a) und (2b)) bzw. Figur 9 (Verbindung (2a,2b) zu (2c)) und mit einer Ausnehmung für eine U-Naht (3a) versehen.
- Bodenplatte (2c): Die Bodenplatte (2c) wurde aus einer gesinterten W-Ronde mit einer Wandstärke von 20 mm hergestellt. Die Ronde (2c) wurde einseitig (Bodeninnenseite des fertigen Behälters (1)) mittels IVPS mit einer W-Schicht (4b) versehen. Die Schichtdicke betrug ca. 300 µm. Für den Spritzprozess wurde ein handelsübliches W Plasma-Spritzpulver verwendet. Der IVPS-Spritzprozess wurde mit für Refraktärmetallen üblichen Parametern (siehe beispielsweise EP 0 874 385 A1) durchgeführt. Die Bodenplatte (2c) wurde an den zu verbindenden Stößen mittels Kontourfräsen mit einem Profil (5c) und mit einer Ausnehmung für eine U-Naht (3a) entsprechend Figur 9 versehen.

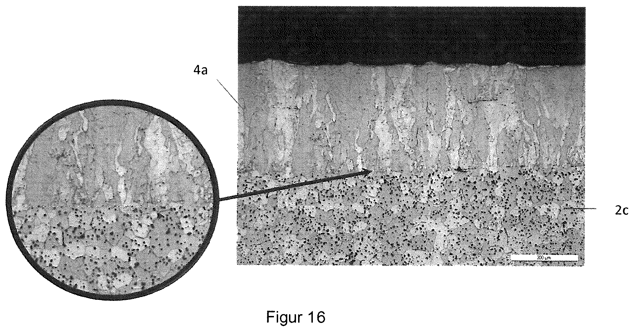

Die Teile (2a,b,c) wurden anschließend durch Verstemmen im Bereich (5b) form- und kraftschlüssig zueinander fixiert und miteinander verbunden (siehe Figuren 9 und 14). Das stoffschlüssige Verbinden der Teile (2a,b,c) erfolgte über eine thermisch gespritzte U-Naht (3a) aus W, die durch IVPS hergestellt wurde. Dazu wurden die aufgespannten Teile in einer Halterung in einer vakuumtauglichen Spritzkammer montiert. Für den Spritzprozess wurde wiederum ein handelsübliches W Plasma-Spritzpulver verwendet. Der IVPS-Spritzprozess wurde mit für Refraktärmetallen üblichen Parametern (siehe beispielsweise EP 0 874 385 A1) durchgeführt. Nach dem Spritzprozess wurde der Rundbehälter (1) aus der Vakuumkammer entnommen und die Stirnflächen mittels zerspanender Bearbeitung (Fräsen, Schleifen) bearbeitet. Die Außenseite des Bodens wurde ebenfalls mit einer ca. 300 µm dicken W-Schicht (4a) versehen. In weiterer Folge wurde in diesem Rundbehälter (1) Aluminiumoxid gemäß Beispiel 1 aufgeschmolzen. Die metallographische Untersuchung zeigte keine Penetration von Aluminiumoxid im Bereich der stoffschlüssigen Verbindung. Figur 16 zeigt, dass die W-Schicht (4a) weniger Poren als der W-Sinterplatte (2c) aufweist.

### Beispiel 3

Es wurde ein Rechteckbehälter (1) aus Mo-1 Ma% ZrO₂ gemäß Figur 4 hergestellt. Für die Herstellung wurden folgende Teile (2d,e,f) eingesetzt:
- Teil (2f), der die Boden- und Seitenflächen längsseitig bildet: Dieser Teil (2f) wurde aus einer U-förmig geschmiedeten Mo-1 Ma% ZrO₂ Platte hergestellt, die allseitig bearbeitet und geschliffen wurde. Der Teil (2f) wurde an den zu verbindenden Stößen mittels Kontourfräsen mit einem Profil (5c) und mit einer Ausnehmung für eine U-Naht (3a) entsprechend Figur 9 versehen.
- Teile (2d,e), die die Seitenflächen breitseitig bilden: Die Teile (2d,e) wurden aus einer gewalzten Mo Platte Mo-1 Ma% ZrO₂ hergestellt, die allseitig bearbeitet und geschliffen war. Die Wandstärke betrug 8 mm. Die Teile (2d,e) wurde an den zu verbindenden Stößen mittels Kontourfräsen mit einem Profil (5b) und mit einer Ausnehmung für eine U-Naht (3a) entsprechend Figur 9 versehen.

Das form- und kraftschlüssige Fixieren der Teile (2d,e,f) erfolgte durch Verstemmen (5c), das stoffschlüssige Verbinden über eine thermisch gespritzte Mo Schicht (3a) mit U-Nahtform, die durch IVPS hergestellt wurde. Die Herstellung der Schicht (3a) erfolgte gemäß Beispiel 1. Nach dem Spritzprozess wurde der Rechteckbehälter (1) aus der Vakuumkammer entnommen und die Stirnflächen mittels zerspanender Bearbeitung (Fräsen, Schleifen) bearbeitet.

### Beispiel 4

Für die Herstellung eines Rundbehälters gemäß Figur 2 wurden folgende Teile (siehe Figur 1) eingesetzt:
- Zwei Hohlzylindersegmente (2a,b): Die Hohlzylindersegmente (2a,b) wurden aus gewalzten Mo-0,7 Ma% La₂O₃ Platten hergestellt, die einseitig auf eine Dicke von 20 mm gefräst wurden. Die Platten werden zu Halbschalen (2a,b) geformt. Die Teile (2a,b) wurden an den zu verbindenden Stößen mittels Kontourfräsen mit einem Profil (5b) und mit einer Ausnehmung für eine U-Naht (3a) entsprechend Figur 10 versehen.
- Bodenplatte (2c): Die Bodenplatte (2c) wurde aus einer gewalzten W-Ronde mit einer Wandstärke von 20 mm hergestellt. Die Bodenplatte (2c) wurde an den zu verbindenden Stößen mittels Kontourfräsen mit einem Profil und mit einer Ausnehmung für eine U-Naht (3a) entsprechend Figur 10 versehen.

Die Teile (2a,b,c) wurden anschließend über die Nut-Feder-Verbindung (5b) formschlüssig zueinander fixiert. Das stoffschlüssige Verbinden der Teile (2a,b,c) erfolgte über eine thermisch gespritzte Mo U-Naht (3a), die durch IVPS hergestellt wurde. Die Herstellung der Schicht (3a) erfolgte gemäß Beispiel 1. Nach dem Spritzprozess wurde der Rundbehälter (1) aus der Vakuumkammer entnommen und die Stirnflächen mittels zerspanender Bearbeitung (Fräsen, Schleifen) bearbeitet.

### Beispiel 5

Ein Ring aus Inconel 718 mit der Zusammensetzung 0,04 Ma% C; 19 Ma% Cr; 3,0 Ma% Mo; 52,5 Ma% Ni; 0,9 Ma% Al; ≤0,1 Ma% Cu; 5,1 Ma% Nb; 0,9 Ma% Ti und 19 Ma% Fe wurde mit einer Bodenplatte (2c) aus Mo verbunden. Die stoffschlüssige Verbindung wurde über eine gespritzte V-Naht (3b) (siehe Figur 6) realisiert. Als Material für die Spritznaht wurde Mo verwendet. Auch mit artfremden (Ni-Basis-Superlegierung und Refraktärmetall) Werkstoffen konnte ein Rundbehälter (1) mit einer dichten, stoffschlüssigen Verbindung hergestellt werden.

### Beispiel 6

Mit Mo-Platten, die aus einer Walzplatte mit einer Stärke von 15 mm gefertigt wurden, wurden erfolgreich unterschiedliche Varianten für ein formschlüssiges Fixieren und stoffschlüssiges Verbinden erprobt. Auch Dichtschichten wurden hergestellt. Als Schichtmaterial wurde jeweils Mo verwendet (Spritzbedingungen gemäß Beispiel 1).

Die unterschiedlichen Ausführungen sind in den folgenden Figuren dargestellt:
- Figur 7: Stoffschlüssiges Verbinden durch eine U-Naht (3a), Aufbringen einer außenseitigen Dichtschicht (4a)
- Figur 8: Formschlüssiges Fixieren durch Verstiften (5a), stoffschlüssiges Verbinden durch eine U-Naht (3a), Aufbringen einer außenseitigen Dichtschicht (4a)
- Figur 11: Formschlüssiges Fixieren durch eine Nut-Feder Verbindung (5b), stoffschlüssiges Verbinden durch eine flächig aufgebrachte Schicht (3c), Aufbringen einer außenseitigen (4a) und innenseitigen (4b) Dichtschicht
- Figur 12: Formschlüssiges Fixieren durch eine Nut-Feder Verbindung (5b), stoffschlüssiges Verbinden durch eine U-Naht (3a)
- Figur 13: Formschlüssiges Fixieren durch eine Nut-Feder Verbindung (5b), Aufbringen einer Dichtschicht (4a,b), stoffschlüssiges Verbinden durch eine flächig aufgebrachte Mo-Spritzschicht (3c)

## Patentansprüche

1. Behälter (1), der zumindest zwei miteinander verbundene Teile (2a, 2b, 2c, 2d, 2e, 2f) umfasst, welche Teile einen Bodenteil und einen Seitenteil oder ein Hohlzylindersegment des Behälters (1) bilden, wobei die Teile (2a, 2b, 2c, 2d, 2e, 2f) aus Refraktärmetall oder einer Refraktärmetalllegierung mit einem Refraktärmetallgehalt > 80 Ma% bestehen,
wobei die zumindest zwei Teile (2a, 2b, 2c, 2d, 2e, 2f) zumindest bereichsweise über eine thermische Spritzschicht (3a, 3b, 3c) zur Ausbildung des Behälters (1) miteinander verbunden sind.

2. Behälter (1) nach Anspruch 1, **dadurch gekennzeichnet, dass** die thermische Spritzschicht (3) mit zumindest einem Teil (2a, 2b, 2c, 2d, 2e, 2f) eine Verbindung mit zumindest einem Wirkprinzip ausgewählt aus der Gruppe Stoffschluss und Formschluss bildet.

3. Behälter (1) nach Anspruch 1 oder 2, **dadurch gekennzeichnet, dass** die thermische Spritzschicht (3a, 3b, 3c) als Naht (3a, 3b) ausgebildet ist.

4. Behälter (1) nach einem der vorangehenden Ansprüche, **dadurch gekennzeichnet, dass** die zumindest zwei Teile (2a, 2b, 2c, 2d, 2e, 2f) zumindest bereichsweise so ausgebildet sind, dass diese durch einen Form-, Kraft- und/oder Stoffschluss zueinander fixiert oder miteinander verbunden sind.

5. Behälter (1) nach einem der vorangehenden Ansprüche, **dadurch gekennzeichnet, dass** das Refraktärmetall Molybdän oder Wolfram ist.

6. Behälter (1) nach einem der vorangehenden Ansprüche, **dadurch gekennzeichnet, dass** die thermische Spritzschicht (3a, 3b, 3c) durch Plasmaspritzen gebildet ist.

7. Behälter (1) nach einem der vorangehenden Ansprüche, **dadurch gekennzeichnet, dass** die thermische Spritzschicht (3a, 3b, 3c) aus einem Refraktärmetall gebildet ist.

8. Behälter (1) nach einem der vorangehenden Ansprüche, **dadurch gekennzeichnet, dass** behälterinnen- und/oder behälteraußenseitig eine Dichtschicht (4a, 4b) aufgebracht ist.

9. Behälter (1) nach einem der vorangehenden Ansprüche, **dadurch gekennzeichnet, dass** die thermische Spritzschicht (3a, 3b, 3c) und/oder die Dichtschicht (4a, 4b) dicht gegenüber einer keramischen Schmelze ist.

10. Verfahren zur Herstellung eines Behälters (1), der zumindest bereichsweise aus Refraktärmetall oder einer Refraktärmetalllegierung mit einem Refraktärmetallgehalt > 80 Ma% besteht,
**dadurch gekennzeichnet,**
**dass** dieses zumindest die folgenden Schritte umfasst:
- Herstellen von zumindest zwei Teilen (2a, 2b, 2c, 2d, 2e, 2f);
- Zumindest bereichsweises Aufbringen einer thermischen Spritzschicht (3a, 3b, 3c), sodass die thermische Spritzschicht (3a, 3b, 3c) zumindest bereichsweise die zumindest zwei Teile (2a, 2b, 2c, 2d, 2e, 2f) stoff- oder formschlüssig verbindet.

11. Verfahren nach Anspruch 10 zur Herstellung eines Behälters (1) nach einem der Ansprüche 1 bis 9.

12. Verfahren nach Anspruch 10 oder 11, **dadurch gekennzeichnet, dass** das Herstellen der Teile (2a, 2b, 2c, 2d, 2e, 2f) zumindest einen Herstellschritt der Gruppe Pulverpressen, Sintern, heißisostatisches Pressen und Umformen umfasst.

13. Verfahren nach einem der Ansprüche 10 bis 12, **dadurch gekennzeichnet, dass** die Teile (2a, 2b, 2c, 2d, 2e, 2f) mechanisch so bearbeitet werden, dass diese zumindest bereichsweise form-, kraft- und/oder stoffschlüssig zueinander fixiert oder miteinander verbunden werden können.

14. Verfahren nach einem der Ansprüche 10 bis 13, **dadurch gekennzeichnet, dass** die Teile (2a, 2b, 2c, 2d, 2e, 2f) durch ein thermisches Spritzverfahren ausgewählt aus der Gruppe bestehend aus Plasmaspritzen, insbesondere Vakuumplasmaspritzen, Lichtbogenspritzen, Flammspritzen, Detonationsspritzen, Kaltgasspritzen und Laserspritzen verbunden werden.

15. Verfahren nach einem der Ansprüche 10 bis 14, **dadurch gekennzeichnet, dass** der Behälter (1) unter Einwirkung eines Slurrys und optional einer nachfolgenden Glühung versiegelt wird.

## Claims

1. A container (1), which comprises at least two parts (2a, 2b, 2c, 2d, 2e, 2f) connected to one another, which parts form a bottom part and a side part or a hollow cylinder segment of the container (1), the parts (2a, 2b, 2c, 2d, 2e, 2f) consisting of refractory metal or a refractory metal alloy with a refractory metal content > 80 wt.%,
wherein the at least two parts (2a, 2b, 2c, 2d, 2e, 2f) are connected to one another at least in some regions by way of a thermally sprayed layer (3a, 3b, 3c) for foming the container (1).

2. The container (1) as claimed in claim 1, **characterized in that** the thermally sprayed layer (3) forms, with at least one part (2a, 2b, 2c, 2d, 2e, 2f), a connection with at least one principle of action selected from the group metallurgical bonding and interlocking engagement.

3. The container (1) as claimed in claim 1 or claim 2, **characterized in that** the thermally sprayed layer (3a, 3b, 3c) is formed as a seam (3a, 3b).

4. The container (1) as claimed in claim 1, **characterized in that** the at least two parts (2a, 2b, 2c, 2d, 2e, 2f) are formed at least in some regions in such a way that they are fixed in relation to one another or connected to one another by at least one of interlocking, force-locking engagement and metallurgically bonding.

5. The container (1) as claimed in one of the preceding claims, **characterized in that** the refractory metal is molybdenum or tungsten.

6. The container (1) as claimed in one of the preceding claims, **characterized in that** the thermally sprayed layer (3a, 3b, 3c) is formed by plasma spraying.

7. The container (1) as claimed in one of the preceding claims, **characterized in that** the thermally sprayed layer (3a, 3b, 3c) is formed from a refractory metal.

8. The container (1) as claimed in one of the preceding claims, **characterized in** an impermeable layer (4a, 4b) is applied on at least one of the inside of the container and the outside of the container.

9. The container (1) as claimed in one of the preceding claims, **characterized in that** at least one of the thermally sprayed layer (3a, 3b, 3c) and the impermeable layer (4a, 4b) is impermeable to a ceramic melt.

10. A method for producing a container (1), which consists at least in some regions of refractory metal or a refractory metal alloy with a refractory metal content > 80 wt.%,
**characterized**
**in that** it comprises at least the following steps:
- producing at least two parts (2a, 2b, 2c, 2d, 2e, 2f);
- applying a thermally sprayed layer (3a, 3b, 3c) at least in some regions, so that the thermally sprayed layer (3a, 3b, 3c) at least in some regions connects the at least two parts (2a, 2b, 2c, 2d, 2e, 2f) in a metallurgically bonding or interlocking manner.

11. A method according to claim 10 for producing a container (1) as claimed in one of claims 1 to 9.

12. The method of claim 10 or 11, **characterized in that** production of the at least two parts (2a, 2b, 2c, 2d, 2e, 2f) comprises at least one production step from the group powder pressing, sintering, hot isostatic pressing and forming.

13. The method as claimed in one of the claims 10 to 12, **characterized in that** the at least two parts (2a, 2b, 2c, 2d, 2e, 2f) are machined in such a way that they can at least in some regions be fixed in relation to one another or connected to one another by at least one of interlocking, force-locking and metallurgically bonding.

14. The method as claimed in one of the claims 10 to 13, **characterized in that** the at least two parts (2a, 2b, 2c, 2d, 2e, 2f) are connected by a thermal spraying method selected from the group consisting of plasma spraying, electric-arc spraying, flame spraying, detonation spraying, cold-gas spraying and laser spraying.

15. The method as claimed in one of the claims 10 to 14, **characterized in that** the container (1) is sealed by action of a slurry and optional subsequent annealing.

## Revendications

1. Contenant (1), qui comprend au moins deux parties (2a, 2b, 2c, 2d, 2e, 2f) reliées entre elles, lesquelles parties forment une partie de fond et une partie latérale ou un segment cylindrique creux du contenant (1), les parties (2a, 2b, 2c, 2d, 2e, 2f, 2f, 2c, 2d, 2e, 2f) étant constituées de métal réfractaire ou d'un alliage de métal réfractaire ayant une teneur en métal réfractaire > 80 % en masse,
les au moins deux parties (2a, 2b, 2c, 2d, 2e, 2f) étant reliées entre elles au moins par zones par l'intermédiaire d'une couche de pulvérisation thermique (3a, 3b, 3c) pour former le contenant (1).

2. Contenant (1) selon la revendication 1, **caractérisé en ce que** la couche de pulvérisation thermique (3) forme avec au moins une partie (2a, 2b, 2c, 2d, 2e, 2f) une liaison avec au moins un principe actif choisi dans le groupe de la liaison par la matière et de la liaison par la forme.

3. Contenant (1) selon la revendication 1 ou 2, **caractérisé en ce que** la couche de pulvérisation thermique (3a, 3b, 3c) est réalisée sous la forme d'un joint (3a, 3b).

4. Contenant (1) selon l'une quelconque des revendications précédentes, **caractérisé en ce que** les au moins deux parties (2a, 2b, 2c, 2d, 2e, 2f) sont réalisées au moins par zones de telle sorte que celles-ci sont fixées ou reliées entre elles par une liaison par la forme, par la force et/ou par la matière.

5. Contenant (1) selon l'une quelconque des revendications précédentes, **caractérisé en ce que** le métal réfractaire est le molybdène ou le tungstène.

6. Contenant (1) selon l'une quelconque des revendications précédentes, **caractérisé en ce que** la couche de pulvérisation thermique (3a, 3b, 3c) est formée par pulvérisation au plasma.

7. Contenant (1) selon l'une quelconque des revendications précédentes, **caractérisé en ce que** la couche de pulvérisation thermique (3a, 3b, 3c) est formée à partir d'un métal réfractaire.

8. Contenant (1) selon l'une quelconque des revendications précédentes, **caractérisé en ce qu'**une couche d'étanchéité (4a, 4b) est appliquée sur le côté intérieur et/ou extérieur du contenant.

9. Contenant (1) selon l'une quelconque des revendications précédentes, **caractérisé en ce que** la couche de pulvérisation thermique (3a, 3b, 3c) et/ou la couche d'étanchéité (4a, 4b) sont étanches par rapport à une masse fondue de céramique.

10. Procédé de fabrication d'un contenant (1), qui est constitué au moins par zones de métal réfractaire ou d'un alliage de métal réfractaire ayant une teneur en métal réfractaire > 80 % en masse,
**caractérisé en ce que**
celui-ci comprend au moins les étapes suivantes :
- la fabrication d'au moins deux parties (2a, 2b, 2c, 2d, 2e, 2f) ;
- l'application au moins par zones d'une couche de pulvérisation thermique (3a, 3b, 3c), de telle sorte que la couche de pulvérisation thermique (3a, 3b, 3c) relie au moins par zones les au moins deux parties (2a, 2b, 2c, 2d, 2e, 2f) par la matière ou par la forme.

11. Procédé selon la revendication 10 pour la fabrication d'un contenant (1) selon l'une quelconque des revendications 1 à 9.

12. Procédé selon la revendication 10 ou 11, **caractérisé en ce que** la fabrication des parties (2a, 2b, 2c, 2d, 2e, 2f) comprend au moins une étape de fabrication du groupe du pressage de poudre, du frittage, du pressage isostatique à chaud et du formage.

13. Procédé selon l'une quelconque des revendications 10 à 12, **caractérisé en ce que** les parties (2a, 2b, 2c, 2d, 2e, 2f) sont usinées mécaniquement de telle sorte que celles-ci peuvent être fixées ou reliées entre elles au moins par zones par liaison par la forme, la force et/ou la matière.

14. Procédé selon l'une quelconque des revendications 10 à 13, **caractérisé en ce que** les parties (2a, 2b, 2c, 2d, 2e, 2f) sont reliées par un procédé de pulvérisation thermique choisi dans le groupe constitué par la pulvérisation au plasma, notamment la pulvérisation au plasma sous vide, la pulvérisation à l'arc électrique, la pulvérisation à la flamme, la pulvérisation par détonation, la pulvérisation au gaz froid et la pulvérisation au laser.

15. Procédé selon l'une quelconque des revendications 10 à 14, **caractérisé en ce que** le contenant (1) est scellé sous l'action d'une pâte et éventuellement d'un recuit ultérieur.
